# EUROPÄISCHE PATENTANMELDUNG

(11) **EP 1 386 980 A2**
(43) Veröffentlichungstag der Anmeldung: **04.02.2004**
(21) Anmeldenummer: 03011789.9
(22) Anmeldetag: 24.05.2003
(51) Int. Cl.: C23C 16/04

(54) **Verfahren zur Innenbeschichtung von Gasturbinenschaufeln**

(30) Priorität: 04.06.2002 DE 10224632
(71) Anmelder: MTU Aero Engines GmbH, 80995 München (DE)
(72) Erfinder: Seidel, Frank, 30916 Isernhagen H.B. (DE)
(74) Vertreter: Zacharias, Frank L.

(57) **Zusammenfassung**

Verfahren zur Innenbeschichtung von Gasturbinenschaufeln mit Diffusionsschutzschichten mittels eines CVD-Prozesses in einem Beschichtungsraum bei erhöhter Temperatur unter Verwendung eines Prozessgases, eines Halogenids als Aktivator und eines metallischen Materials als Donator zur Erzeugung von Beschichtungsgas im Beschichtungsraum.

Bei Beschichtungstemperatur wird der Druck im Beschichtungsraum durch Gasabsaugung reduziert, anschließend erfolgt eine Wiederbefüllung unter Druckanstieg mit Halogenidgas zur direkten Neubildung von Beschichtungsgas mit dem Donatormaterial.

## Beschreibung

Die Erfindung betrifft ein Verfahren zur Innenbeschichtung von Gasturbinenschaufeln, mit oder ohne gleichzeitige Außenbeschichtung, mit Diffusionsschutzschichten mittels eines CVD-Prozesses, gemäß dem Oberbegriff des Patentanspruchs 1.

Das Beschichten von Bauteilen von Gasturbinen wird bekanntlich eingesetzt, um funktionelle Verbesserungen, wie Schutz gegen Verschleiß, Korrosion, Heißgaskorrosion, eine Verringerung des Wärmeübergangs u.ä. zu erzielen.

Sowohl bei Fluggasturbinen als auch bei stationären Turbinen sind aufgrund der hohen Betriebstemperaturen insbesondere im Turbinenbereich Maßnahmen zur Minderung von Oxidation und Heißgas-Korrosion notwendig, wobei gegen Oxidation beispielsweise Aluminid-Schutzschichten und gegen Korrosion beispielsweise Inchromier-Schutzschichten besonders wirksam sind.

Mittels sogenannter CVD-Beschichtung (Chemical Vapor Deposition) werden die Schichten in Diffusionsprozessen aus der Gasphase bei hoher Temperatur auf den Bauteilen abgeschieden. Aluminid-Schichten werden beispielsweise durch die Reaktion eines Beschichtungsgases, wie z.B. AlF (Aluminiumfluorid) bei etwa 900 - 1100 °C mit den zu beschichtenden Oberflächen der Bauteile erzeugt.

Anwendung finden vielfach Kastensysteme, innerhalb derer die zu beschichtenden Bauteile aufgebaut werden, wobei räumlich getrennt über, neben und unterhalb der Teile aus einem metallischen Donatormaterial (z.B. AlCr, CoAI), einem Aktivator (z.B. AlF₃, NH₄F, bei Raumtemperatur zunächst kristallin) und einem Prozeßgas (z.B. Ar, H₂) bei hohen Temperaturen Beschichtungsgas (Aluminiumfluorid, AlF) gebildet wird. In sogenannten Retortenöfen können mehrere Kästen gleichzeitig zum Beschichten verwendet werden.

Zur Beschichtung von Innenflächen von Turbinenschaufeln sind nun die Beschichtungsgase mittels besonderer Rohrleitungen und Anströmvorrichtungen in die Hohlräume der Turbinenschaufeln zu leiten, was aufwendig und störanfällig ist, da die hohen Prozeßtemperaturen von 1100 °C Abdichtungsprobleme verursachen. Temperaturgefälle können ebenfalls sehr problematisch sein, da die Aktivgase (z.B. AlF, AICI) an den kalten Leitungsteilen kondensieren können. Sowohl infolge von Leckagen als auch von frühzeitigem Gaszerfall kann es zu schwer feststellbaren Fehlbeschichtungen kommen.

Hier setzt nun die Erfindung an, deren Aufgabe es ist, ein Verfahren zur effektiven und prozesssicheren Innenbeschichtung von Gasturbinenschaufeln zu schaffen, das die genannten Nachteile vermeidet.

Diese Aufgabe wird durch die in Anspruch 1 gekennzeichneten Merkmale gelöst, in Verbindung mit den gattungsbildenden Merkmalen in dessen Oberbegriff.

Im Vergleich zu den verbreiteten Verfahren zur Innenbeschichtung von Gasturbinenschaufeln wird bei dem neuen Verfahren die hinreichende Versorgung der Innenflächen mit Beschichtungsgasen nicht durch Einspeisevorrichtungen realisiert. Vielmehr wird durch Druckvariation im Beschichtungsraum der zur effektiven Beschichtung der Innenwandungen nötige Gastransport in die Hohlräume der Schaufeln ermöglicht. Dem Verlust der beschichtungsaktiven Gase infolge des Abpumpens wird entgegengewirkt, indem beim Druckanstieg direkt wieder neues Beschichtungsgas generiert wird. Dies wird erfindungsgemäß derart realisiert, dass das Fluten des Beschichtungsraums beim Druckanstieg mit einem Halogenid-Gas (z.B. HF) erfolgt, welches mit dem im Beschichtungsraum vorhandenen Donatormaterial sofort neues Beschichtungsgas (AlF) bildet. Das Halogenid-Gas wirkt dabei als Aktivator. Durch die sofortige Neubildung von Beschichtungsgas wird der Beschichtungsprozess mit voller Aktivität fortgesetzt.

In den Unteransprüchen sind bevorzugte Ausgestaltungen des Verfahrens nach dem Hauptanspruch gekennzeichnet.

Durch das Verfahren nach der Erfindung wird eine gleichmäßige Innenbeschichtung der Gasturbinenschaufeln gewährleistet, entfallen bisher notwendige Gasversorgungssysteme sowie bisher notwendige Adapter für jede einzelne der zu beschichtenden Gasturbinenschaufeln. Das Beschichten erfolgt mit hoher Qualität trotz vergleichsweise einfacher und robuster Verfahrensweise.

Damit wird auch für die Reparatur von Turbinenschaufeln ein Weg eröffnet, um deren Innenflächen in bisher nicht gekannter Effizienz und Qualität zu beschichten.

Selbstverständlich eignet sich das erfindungsgemäße Verfahren auch für die Beschichtung der Schaufeln von Industriegasturbinen.

Das erfindungsgemäße Verfahren eignet sich neben dem Alitieren mit angepasster Donator-Aktivator-Kombination zum Aufbringen weiterer thermochemischer Schichtsysteme, wie z.B. zum Inchromieren, zum Borieren und Silicieren sowie für Kombinationen aus diesen Prozessen.

### Ausführungsbeispiel

Die zu beschichtenden Gasturbinenschaufeln der Hochdruckturbine eines Flugtriebwerks (hergestellt aus einer einkristallinen Superlegierung) werden zum Beschichten in das Kastensystem einer Beschichtungsanlage eingebracht, die auch zum Betrieb im Unterdruck sowie zum Einsatz von gasförmigem Fluorwasserstoff (HF) geeignet ist.

Als Donator kommt AlCr, als Start-Aktivator AlF₃ zur Anwendung. Die Prozesstemperatur beträgt + 1085 °C. Für das Druckpulsen wird der Druck im Beschichtungsraum fünfmal von etwa 1000 mbar auf etwa 100 mbar reduziert, wobei das Fluten des Kastensystems beim Druckanstieg jeweils mit einem H₂-HF-Gasgemisch erfolgt. Das Gasgemisch strömt direkt auf das Donatormaterial.

Infolge der Versorgung der Schaufelinnenflächen mit frischem Beschichtungsgas (AlF) beim Druckanstieg, werden auf den Innenflächen Aluminid-Schichten erzeugt, deren Dicke mehr als 35 µm betragen, die gleichzeitig erzeugten Außenschichtdicken liegen bei 55 µm.

Durch lokale Abdeckungen auf den Schaufelaußenflächen kann die Schichtbildung dort gezielt unterbunden werden.

## Patentansprüche

1. Verfahren zur Innenbeschichtung von Gasturbinenschaufeln, mit oder ohne gleichzeitige Außenbeschichtung, mit Diffusionsschutzschichten mittels eines CVD-Prozesses in einem gegenüber der Umgebung abdichtbaren Beschichtungsraum bei erhöhter Temperatur unter Verwendung eines inerten und/oder eines reaktiven Prozessgases, mindestens eines Halogenids als Aktivator und mindestens eines metallischen Materials als Donator, wobei der Aktivator und der Donator im Beschichtungsraum zur Erzeugung von Beschichtungsgas bereitgestellt werden, **dadurch gekennzeichnet, dass** bei Beschichtungstemperatur der zunächst etwa dem Umgebungsdruck entsprechende Druck im Beschichtungsraum durch Gasabsaugung reduziert wird und anschließend eine Wiederbefüllung unter Druckanstieg etwa bis Umgebungsdruck zumindest großteils mit Halogenidgas zur direkten Neubildung von Beschichtungsgas mit dem Donatormaterial erfolgt.

2. Verfahren nach Anspruch 1, **dadurch gekennzeichnet, dass** der Druckzyklus mehrmalig, vorzugsweise drei- bis sechsmalig erfolgt und der Druck dabei zeitweise von etwa 1000 mbar auf 100 mbar oder weniger reduziert wird.

3. Verfahren nach Anspruch 1 oder 2, **dadurch gekennzeichnet, dass** das Verfahren innerhalb des Beschichtungsraums in Kastensystemen ausgeführt wird, wobei gasdurchlässige, die Gasturbinenschaufeln einschließlich des Aktivators und des Donatormaterials enthaltende Kästen systematisch angeordnet werden.

4. Verfahren nach einem oder mehreren der vorhergehenden Ansprüche, **dadurch gekennzeichnet, dass** es zum Alitieren, Inchromieren, Borieren, Silicieren oder zu Kombinationen hiervon angewendet wird.

5. Verfahren nach einem oder mehreren der vorhergehenden Ansprüche, **dadurch gekennzeichnet, dass** Kühlluft-Einlassöffnungen in den Füßen der Gasturbinenschaufeln offen und für das Beschichtungsgas zugänglich angeordnet werden.
